**Europäisches Patentamt**

**European Patent Office**

**Office européen des brevets**

(19)

(11) **EP 1 278 302 A2**

(12) **EUROPEAN PATENT APPLICATION**

(43) Date of publication:
**22.01.2003 Bulletin 2003/04**

(51) Int Cl.$^7$: **H03H 11/12**

(21) Application number: **02396080.0**

(22) Date of filing: **29.05.2002**

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI** | (72) Inventor: **Sillanpää, Tero**<br>**00800 Helsinki (CH)** |
| (30) Priority: **27.06.2001 FI 20011381** | (74) Representative: **Äkräs, Tapio Juhani et al**<br>**Oy Kolster Ab,**<br>**Iso Roobertinkatu 23,**<br>**P.O. Box 148**<br>**00121 Helsinki (FI)** |
| (71) Applicant: **Micro Analog Systems OY**<br>**02770 Espoo (FI)** | |

(54) **RF protection on integrated circuit**

(57)     An integrated circuit chip comprises a reference voltage generator circuit (21), a connection pad (22) for an external input and/or output, an electrostatic discharge (ESD) protection (24) at said connection pad, and a differential amplifier (26) with a differential input transistor pair (261), an output buffer stage (262), and a negative feedback (27). A reference voltage output from said reference voltage generator circuit is connected to the pad and to an input of the differential amplifier. For reducing a variation in the output voltage of the differential amplifier, a low-pass filter circuit ($C_{RF}$, $R_{RF}$) is connected to a signal path between the connection pad and the input of the differential amplifier for attenuating a RF interference signal at the input of the differential pair in the amplifier, and therefore also the output voltage drop caused by a peak detection operation of the differential input transistor pair will stay lower.

Fig. 6

EP 1 278 302 A2

**Description**

**Field of the Invention**

The Invention relates to integrated circuits.

**Background of the Invention**

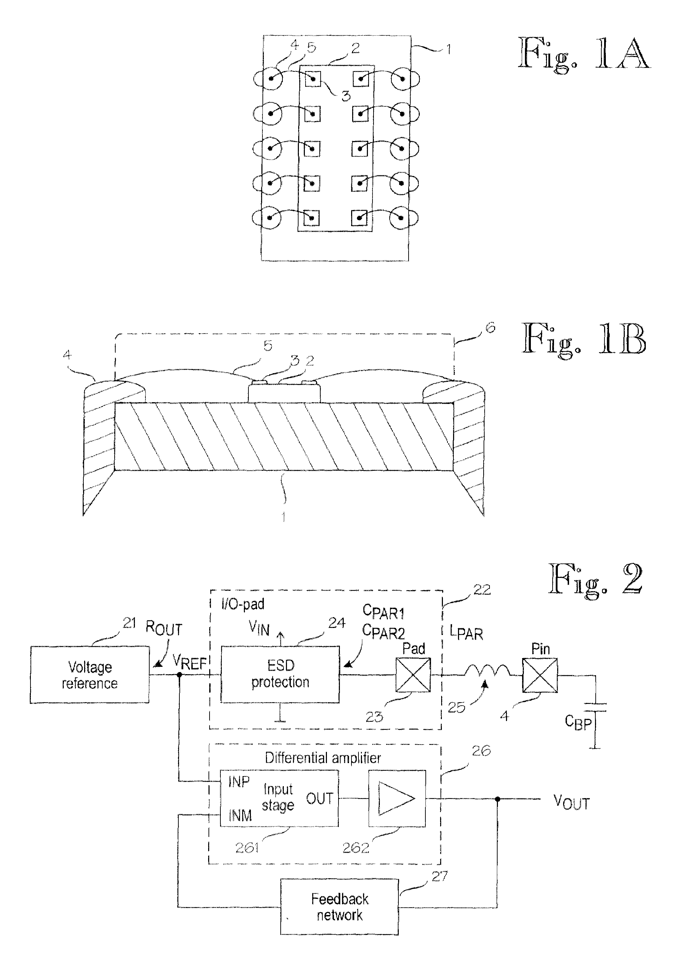

Integrated circuits are well known in the art of electronics and widely used in all kinds of electronic devices. An integrated circuit is usually encapsulated in plastic or ceramic packets, which have metal leads (pins) as signal connections. There are different types of packages (SO, TSSOP, MSOP, QSOP only to name a few of them) with different numbers of connection pins. Referring to Figures 1A and 1B, input/output signals of an integrated circuit are connected to the pins 28 by bonding wires 25, which are attached on one end to an I/O-pad 22 of the integrated chip 2 and on the other end to the pin metal 28 of the package 1. Plastic 6 (or any other suitable package material) is molded around the chip 2, the bonding wires 25 and partly over the pins 28 so that part of each pin 28 is visible outside the molded plastic 6. This encapsulated device may then be soldered to a printed circuit board (PCB) or any other substrate, and the pins 28 are connected by solder to the signal wires of the PCB.

In many integrated circuits there is a voltage reference, which creates a DC-voltage $V_{REF,}$ which is usually temperature compensated and independent of the supply voltage. The voltage reference often involves noise, which must be suppressed. The noise is typically low frequency noise (i.e. at frequencies lower than radio frequencies RF) and therefore an external filter circuit may be needed, typically because large capacitance cannot be implemented on the integrated chip. This means that the output of the reference voltage is connected to an I/O pad on the chip. An example of such a circuit for creating reference voltages on an integrated chip is illustrated in Figure 2. Voltage reference 21 creates a DC-voltage $V_{REF,}$ which is usually independent of the temperature and the supply voltage. The voltage reference 21 is wired to an I/O pad 22 on the chip. The I/O pad 22 has a metal (e.g. aluminum) bonding plate (pad 23) and electrostatic discharge (ESD) protection elements 24 against supply voltage $V_{IN}$ and the ground. Reverse connected diodes or transistors between the input pad 23 and the VIN and the ground, respectively, may embody the ESD protection 24. The pad 23 is further connected to the package pin wire 28 by a bonding wire 25. Usually there is an external bypass capacitor $C_{BP}$ on the printed circuit board. This capacitor $C_{BP}$ is intended to low pass filter noise of the voltage reference generator 21.

In Figure 2, the reference voltage $V_{REF}$ is also applied to a differential amplifier 26 having a negative feedback 27. The differential amplifier comprises a differential input transistor pair 261 and an amplifier stage, for which the differential transistor pair is an input stage. The output of the differential amplifier 26 is connected so that the amplifier is connected through the feedback network 27 to the negative (inverting) input of the amplifier 26. The positive (non-inverting) input is connected directly to the reference voltage $V_{REF}$. The output voltage $V_{OUT}$ of the differential amplifier 26 is applied to other circuits within the integrated chip. Typically the purpose of the differential amplifier 26 is to buffer the reference voltage so that the load (i.e. the other circuits) does not affect the reference voltage $V_{REF}$. The amplifier 26 can also be used for other purposes, such as a linear regulator, etc.

It is an essential requirement that the output voltage $V_{OUT}$ provided by the amplifier 26 from the reference voltage $V_{REF}$ is as stable (constant) as possible. In some applications, the requirements are so strict that only a change of a few hundred micro volts ($\mu V$) may cause a problem to the operation of the circuit. The inventor has observed that it is difficult or even impossible to achieve such accuracy in this type of integrated circuits. The problem is essentially related to integrated circuits. With a discrete solution there is no such problem.

**Disclosure of the Invention**

An object of the present invention is an improved circuit with improved accuracy.

This object is achieved with an integrated circuit chip and an integrated circuit as disclosed in the attached independent claims. The preferred embodiments of the invention are disclosed in the attached dependent claims.

An integrated circuit chip comprises a reference voltage generator circuit, a connection pad for an external input and/or output, an electrostatic discharge (ESD) protection at said connection pad, and a differential amplifier with a differential input transistor pair and a negative feedback. A reference voltage output from said reference voltage generator circuit is connected to the pad and to an input of the differential amplifier. The invention is based on the inventor's finding that a variation in an output from the differential amplifier in such an integrated circuit chip is primarily caused by radio frequency (RF) interference induced to the input of the differential amplifier through the ESD protection at the connection pad, and the operation of the differential input pair of the amplifier as a peak detector for the RF signal. One reason for the peak detection operation of the amplifier is that the interference signal frequency is much higher than the bandwidth of the amplifier, otherwise the amplifier would be able to follow the input voltage signal. But since the signal frequency is much higher than the amplifier bandwidth, the amplifier will only detect the peak value of the interference signal. Thus, an RF signal at the input of the amplifier will cause the amplifier output voltage to decrease. In case there is a burst mode RF interference signal at the connection pad, there will be a voltage change at the output of the differential amplifier. According to the present invention, this major reason for the variation in the output voltage of the differential amplifier is alleviated or removed by a low-pass filter circuit connected to a signal path between the connection pad and the input of the differential amplifier for attenuating radio frequency (RF) interference. As a consequence, the RF interference signal is attenuated at the input of the differential pair in the amplifier, and therefore also the output voltage drop caused by peak detection operation of the amplifier will stay lower. Thus, the output voltage from the amplifier is more stable and accurate and thereby also meets very strict requirements.

**Brief Description of the Drawings**

In the following, the invention will be described in greater detail by means of preferred embodiments with reference to the accompanying drawings, in which

Figures 1A and 2B illustrate an integrated circuit chip assembled into (plastic) packets;
Figure 2 illustrates a convention circuitry in an integrated circuit chip;
Figures 3A and 3B illustrate different embodiments of the input stage 261 in Figure 2;
Figure 4 shows a discrete equivalent of the circuit shown in Figure 2;
Figure 5 is a magnitude plot of a RF signal transfer function for the circuit of Figure 4;
Figure 6 illustrates an embodiment of an integrated circuit chip according to the present invention;
Figure 7 shows a circuit diagram of a simplified RF-signal connection for the circuit shown in Figure 6; and

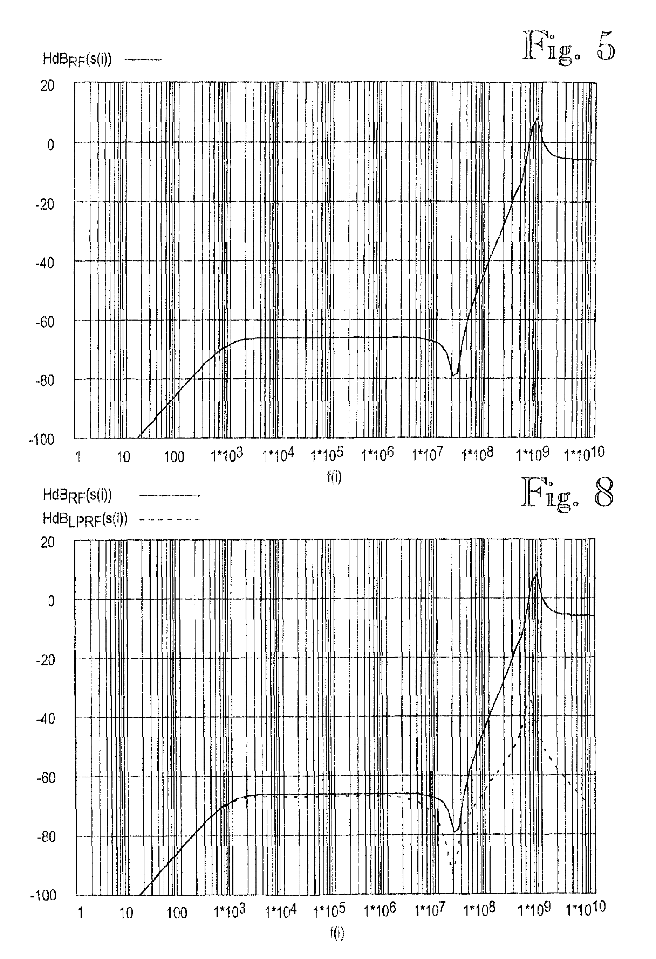

Figure 8 is a magnitude plot of a RF signal transfer function for the circuit of Figure 2 (solid line) and for the circuit of Figure 6 (dotted line).

**Detailed Description**

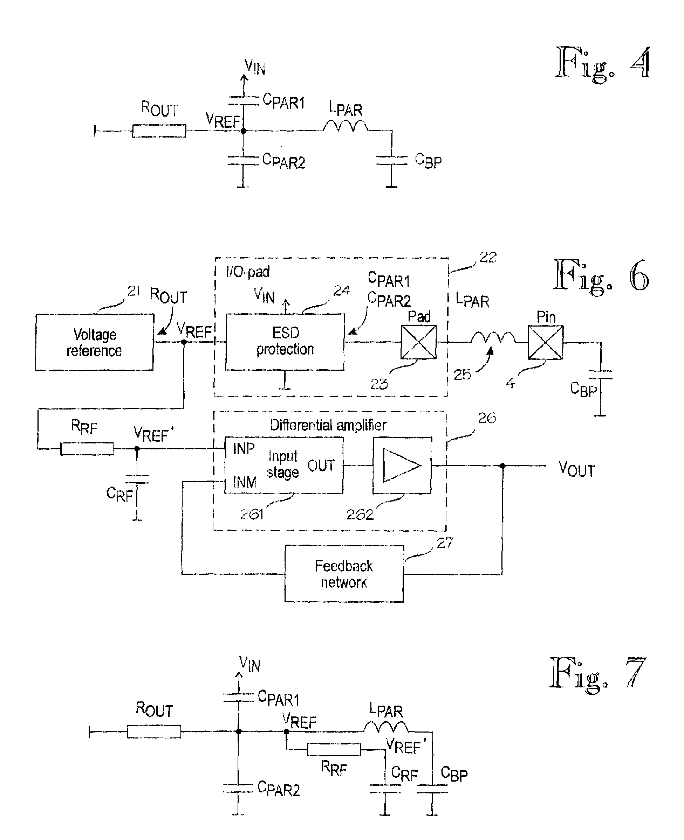

Let us first analyze the circuit of Figure 2 in more detail in order to better understand the findings of the inventor and the basis of the present invention. In Figure 1, the voltage reference has an output resistance $R_{OUT}$. The ESD protection 24 introduces parasitic capacitances $C_{PAR1}$ and $C_{PAR2}$ from the supply voltage $V_{IN}$ and from the ground to the reference voltage $V_{REF}$. Further, the bonding wire 25 and the package pin wire 4 introduce the parasitic inductance $L_{PAR}$ from the chip to the printed circuit board (PCP), to which the pin 4 is connected. Usually there is an external bypass capacitor $C_{BP}$ on the printed circuit board. The capacitor $C_{BP}$ is usually a ceramic capacitance and it also has non-idealities at RF frequencies. However, these non-idealities are not so significant that they should be taken into account in the following theoretical calculations. Figure 4 shows discrete equivalence of the circuitry described above. The transfer function $H_{RF}$ from the supply voltage $V_{IN}$ to the reference voltage $V_{REF}$ is

$$H_{RF}(s) = \frac{V_{REF}}{V_{IN}} \cdot (s) = \frac{C_{PAR1}}{C_{PAR2} + C_{PAR1}} \cdot \frac{s \cdot \left(s^2\right)}{\left(s^3 + a_1 \cdot s^2\right)}$$

in which

$$a_1 = \frac{1}{\left[R_{OUT} \cdot \left(C_{PAR2} + C_{PAR1}\right)\right]}$$

$$b_1 = \left[\frac{\left(C_{PAR1} + C_{PAR2} + C_{BP}\right)}{\left[L_{PAR} \cdot \left[C_{BP} \cdot \left(C_{PAR2} + C_{PAR1}\right)\right]\right]}\right]$$

$$c_1 = \frac{1}{L_{PAR} \cdot C_{BP} \cdot R_{OUT} \cdot C_{PAR2} + R_{OUT} \cdot C_{PAR1} \cdot L_{PAR} \cdot C_{BP}}$$

$$d_1 = \frac{1}{L_{PAR} \cdot C_{BP}}$$

In order to give some idea of the RF signal transfer function for the circuit of Figure 4, its magnitude is plotted with some actual values in Figure 5. The values used are ROUT = 20 kohm, $C_{BP}$ = 10 nf, $L_{PAR}$ = 5 nH, $C_{PAR1}$ = 5 pF, and $C_{PAR2}$ = 5 pF. In Figure 5, the RF noise is attenuated over 60 dB at frequencies below 40 MHz. Above 600 MHz the attenuation is less than or equal to 6 dB. Thus, the RF noise coupling to the reference voltage $V_{REF}$ is quite strong.

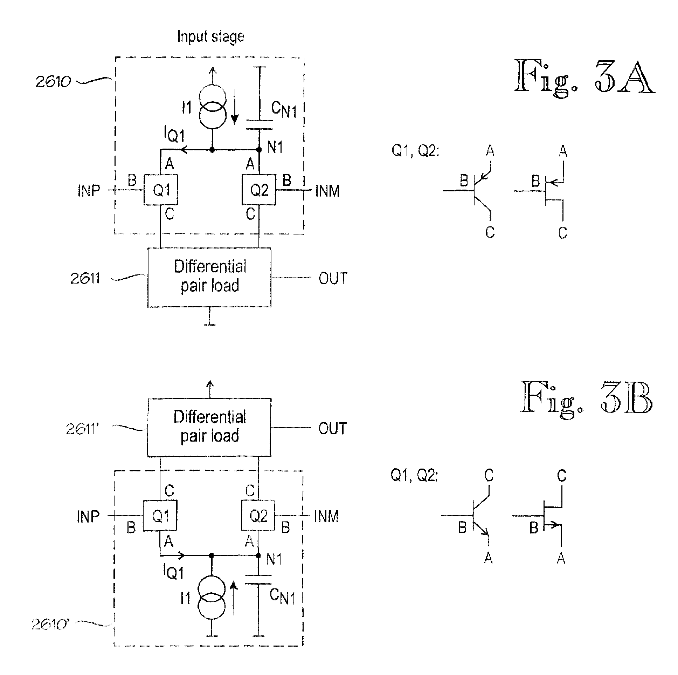

The reference voltage $V_{REF}$ is connected to the input stage 261 of the differential amplifier 26. The input stage 261 is found by the differential transistor pair, the two basic configurations of which are shown in Figure 3A and Figure 3B. In Figure 3A, the transistors Q1 and Q2 in the differential pair are PNP type bipolar transistors or MOSFET transistors, whereas in Figure 3B the transistors Q1 and Q2 are NPN type bipolar transistors or MOSFET transistors. In both cases, the differential pair 2610 or 2611' is connected to a differential pair load 2611 or 2611', respectively. Also, in both configurations the low impedance terminals A (emitters, sources) are connected together and to a current source I1. The current source may be any element suitable for a current source, even a resistor will do. Typically there is a parasitic capacitance $C_{N1}$ associated with the low impedance terminal of input transistors Q1 and Q2, or there may even be an integrated capacitance connected to the common low impedance terminal.

The differential input stage 261 is further connected to the next amplifier stages 262. These altogether establish the differential amplifier 26. The amplifier output $V_{OUT}$ is connected through the feedback network 27 back to the negative (inverting) input INM of the input stage 261. The reference voltage $V_{REF}$ is connected to the positive (non-inverting) input INP of the input stage 261. The purpose of the amplifier 26 is, for example, to buffer the reference voltage so that the subsequent load does not affect the reference voltage $V_{REF}$.

The problem with the differential amplifier 26 is that the differential input pair 2610 or 2610' acts like a peak detector. Let us consider a case in which bipolar transistors Q1 and Q2 are employed. The current source I1, the parasitic capacitance $C_{N1}$ at the emitters of the bipolar transistors Q1 and Q2, as well as the transistor Q1 form a peak detector. If there is, for example, a sine wave signal at the input INP of Q1, the base of Q1 will be modulated. With a lower half wave of the input signal the emitter current $I_{Q1}$ increases. On the other hand, at the positive half of the input signal the emitter current $I_{Q1}$ will decrease. Since the bipolar emitter current $I_{Q1}$ is exponentially dependent on the emitter-base voltage, the current $I_{Q1}$ will increase more in the negative half of the input signal than it will decrease in the positive half of the input signal. Further, the average emitter current $I_{Q1}$ will increase thereby lowering the voltage at mode N1. This will lead to an imbalance of the differential pair, and the amplifier 26 will correct this imbalance itself. Since the node voltage N1 has decreased and the emitter-base voltage of the transistor Q2 is lower than the emitter-base voltage of the transistor Q1, the amplifier 26 will decrease the base voltage of the transistor Q2 by decreasing the output voltage $V_{OUT}$.

One of the requirements for the peak detection is that the input signal frequency (the RF interference) is much higher than the bandwidth of the amplifier 26. Otherwise the amplifier 26 would be able to follow the input voltage signal. But since the signal frequency is much higher than the amplifier bandwidth, the amplifier 26 will only detect the peak value of the input signal. Another requirement for the peak detection is that the input pair is fast enough to peak detect the input signal. This is in most cases valid, even when a unity current gain frequency $f_T$ of a bipolar transistor Q1 is lower than the RF frequency of the input signal, the transistor is still able to partially peak detect the RF signal.

Therefore, it can be concluded that if there is a RF signal at the input of the amplifier 26, the amplifier output voltage $V_{OUT}$ will decrease. In case there is a burst mode RF signal at the supply voltage $V_{IN}$, there will be a voltage drop at the output of the differential amplifier 26. As noted above, this is a problem in many applications.

Preferred embodiments of the invention are illustrated in Figure 6. In Figure 6, the voltage reference 21, the I/O-pad 22, the connection pad 23, the ESD-protection 24, the bonding wire 25, the differential amplifier 26, the input stage 261, the amplifier stage 262, the feedback network 27, and the pin 4 may be similar to those shown in and explained with reference to Figure 2. The new feature according to the invention is a low-pass filter $R_{RF}$-$C_{RF}$ that is connected to the signal path between the I/O pad 22 and the input stage 261 of the differential amplifier. In the embodiments shown, the low-pass filter is found by a series resistor RF connected between the I/O pad 22 and the input INP of the input stage 261, and a capacitor $C_{RF}$ that is connected from the node between the resistor RF and the input INP to the ground. The reference voltage $V_{REF}$ which has passed through the low-pass filter $R_{RF}$-$C_{RF}$ is designated $V_{REF'}$ in Figure 6.

A simplified RF signal connection for the circuitry of Figure 6 is shown in Figure 7. The transfer function HLPRF from the supply voltage VIN to the reference voltage VREF is now

$$H_{LPRF}(s) = \frac{V_{REF}}{V_{IN}} = \frac{C_{PAR1}}{C_{PAR1} + C_{PAR2}} \cdot \frac{s \cdot (s + e_2) \cdot (s^2 + f_2)}{(s^4 + a_2 \cdot s^3 + b_2 \cdot s^2 + c_2 \cdot s + d_2)} \cdot \frac{1}{(s \cdot R_{RF} \cdot C_{RF} + 1)}$$

$$a_2 = \left[ \frac{(R_{RF} \cdot C_{RF} + C_{RF} \cdot R_{OUT} + R_{OUT} \cdot C_{PAR1} + R_{OUT} \cdot C_{PAR2})}{[R_{OUT} \cdot [R_{RF} \cdot [C_{RF} \cdot (C_{PAR1} + C_{PAR2})]]]} \right]$$

$$b_2 = \frac{(R_{OUT} \cdot C_{PAR1} \cdot R_{RF} \cdot C_{RF} + L_{PAR} \cdot C_{BP} + R_{OUT} \cdot C_{PAR2} \cdot R_{RF} \cdot C_{RF} + C_{BP} \cdot R_{OUT} \cdot R_{RF} \cdot C_{RF})}{[R_{OUT} \cdot [L_{PAR} \cdot [C_{BP} \cdot [R_{RF} \cdot [C_{RF} \cdot (C_{PAR1} + C_{PAR2})]]]]]}$$

$$c_2 = \left[ \frac{(R_{RF} \cdot C_{RF} + C_{RF} \cdot R_{OUT} + R_{OUT} \cdot C_{PAR1} + R_{OUT} \cdot C_{PAR2} + C_{BP} \cdot R_{OUT})}{[R_{OUT} \cdot [L_{PAR} \cdot [C_{BP} \cdot [R_{RF} \cdot [C_{RF} \cdot (C_{PAR1} + C_{PAR2})]]]]]} \right]$$

$$d_2 = \frac{1}{(R_{OUT} \cdot C_{PAR1} \cdot R_{RF} \cdot C_{RF} \cdot L_{PAR} \cdot C_{BP} + R_{OUT} \cdot C_{PAR2} \cdot R_{RF} \cdot C_{RF} \cdot L_{PAR} \cdot C_{BP})}$$

$$e_2 = \frac{1}{R_{RF} \cdot C_{RF}}$$

$$f_2 = \frac{1}{L_{PAR} \cdot C_{BP}}$$

It can be seen already from the transfer function $H_{LPRF}$ that if parameter S is high enough S-polynomials s (s+e$_2$)( s^2+f$_2$)/(s^4+ a$_2$s^3+ b$_2$s^2+ c$_2$s+ d$_2$) is approximately equal to 1 as is the case without the RC filter. The remaining gain has the same constant $C_{PAR1}/(C_{PAR1}+C_{PAR2})$ as without the RC-filter and the additional low-pass filter part $1/(sR_{RF}C_{RF}+1)$. The effect of the low-pass filtering can be clearly seen in the magnitude plot of the circuit shown in Figure 5. In Figure 5, the solid line depicts the RF signal transfer function for the circuit of Figure 2 (i.e. without the RC filter) and the dotted line depicts the RF signal transfer function for the circuit of Figure 6 (i.e. with the RC filtering). It can be seen that a RF signal at frequencies higher than 5 MHz, and especially at frequencies higher than 100 MHz is significantly attenuated at the input of the differential pair 261. For example in the mobile terminals, many of the RF interference sources are at frequencies of approximately 1GHz and higher. Finally, as the RF signal is attenuated at the input of the differential amplifier, consequently also the voltage drop in the output voltage $V_{OUT}$ due to the peak detection will stay lower.

It should be appreciated that the description only illustrates the preferred embodiments of the invention. The invention is not, however, limited to these examples but it may vary within the scope and spirit of the appended claims. For example, it is not relevant whether the I/O pad 22 is bonded or not. The same problem exists also if the I/O pad 22 is not bonded and/or there is no external load or external capacitance at all.

## Claims

1. An integrated circuit chip (2) comprising a reference voltage generator circuit (21), a connection pad (22) for an external input and/or output, an electrostatic discharge (ESD) protection (24) at said connection pad, a differential amplifier (26) with a differential input transistor pair (261) and a negative feedback (27), wherein a reference voltage output ($V_{ref}$) from said reference voltage generator circuit (21) is connected to said pad and to an input of said differential amplifier (26), **characterized in that** said chip further comprises a low-pass filter circuit ($R_{RF}$, $C_{RF}$) connected to a signal path (22) between said pad and said input of said differential amplifier (26) for filtering a radio frequency (RF) signal.

2. An integrated circuit chip as claimed in claim 1, **characterized in that** said low-pass filter circuit is a RC low-pass filter circuit ($R_{RF}$, $C_{RF}$).

3. An integrated circuit chip as claimed in claim 2, **characterized in that** said RC low-pass filter circuit comprises a series resistor ($R_{RF}$) between said pad and the input of said amplifier (26), and a capacitor ($C_{RF}$)

4. An integrated circuit chip as claimed in claim 1, 2 or 3, **characterized in that** said differential amplifier (26) is a buffer between said reference voltage generator (21) or a voltage regulator circuit providing a regulated output voltage.

5. An integrated circuit chip as claimed in claim 1, 2 or 3, **characterized in that** said differential amplifier (26) is part of a voltage regulator providing a regulated output voltage.

6. An integrated circuit chip as claimed in any one of the preceding claims, **characterized in that** said connection pad (22) is intended to be connected to an external filtering component ($C_{BP}$) in order to filter off a low-frequency noise appearing in the output of said reference voltage generator (21).

7. An integrated circuit chip as claimed in claim 6, **characterized in that** said external filtering component is a capacitor ($C_{BP}$).

8. An integrated circuit chip as claimed in any ($R_{RF}$, $C_{RF}$) one of the preceding claims, **characterized in that** said RF low-pass filter circuit is arranged to attenuate frequencies higher than 5 MHz, preferably frequencies higher than 100 MHz.

9. An integrated circuit comprising

   a package (1, 6),
   a connection pin (4) in said package (1, 6),
   a chip (2) having a reference voltage generator circuit (21), a connection pad (22) for an external input and/ or output and bonded (5) to said connection pin (4), an electrostatic discharge (ESD) protection (24) at said connection pad (22), a differential amplifier (26) with a differential input transistor pair (261) and a negative feedback (27), wherein a reference voltage output from said reference voltage generator circuit (21) is connected to said pad (22) and to an input of said differential amplifier (26), **characterized in that** said chip further comprises a low-pass filter circuit ($R_{RF}$, $C_{RF}$) connected to a signal path between said pad (22) and said input of said differential amplifier (26) for filtering a radio frequency (RF) signal.

10. An integrated circuit as claimed in claim 9, **characterized in that** said connection pin (4) is intended to be connected to an external filtering component ($C_{BP}$) in order to filter off a low-frequency noise appearing in the output of said reference voltage generator (21).

11. An integrated circuit as claimed in claim 10, **characterized in that** said external filtering component is a capacitor ($C_{BP}$).

Fig. 1A

Fig. 1B

Fig. 2

Input stage

2610

I1    $I_{Q1}$    $C_{N1}$

N1

A    A

INP    B    Q1    Q2    B    INM

C    C

2611    Differential pair load    OUT

Fig. 3A

Q1, Q2:

A    A

B    B

C    C

Fig. 3B

2611'    Differential pair load    OUT

C    C

INP    B    Q1    Q2    B    INM

A    A

N1

$I_{Q1}$

I1    $C_{N1}$

2610'

Q1, Q2:

C    C

B    B

A    A

8

Fig. 4

Fig. 6

Fig. 7

Fig. 5

HdB$_{RF}$(s(i)) ──

f(i)

HdB$_{RF}$(s(i)) ────

HdB$_{LPRF}$(s(i)) ─ ─ ─ ─

Fig. 8

f(i)